(19) Europäisches Patentamt
European Patent Office
Office européen des brevets

(11) **EP 3 084 408 B1**

(12) **EUROPÄISCHE PATENTSCHRIFT**

(45) Veröffentlichungstag und Bekanntmachung des Hinweises auf die Patenterteilung:
**20.01.2021 Patentblatt 2021/03**

(51) Int Cl.:
*G01N 27/02* (2006.01)     *G01V 3/10* (2006.01)
*H03K 17/95* (2006.01)     *G01B 7/00* (2006.01)

(21) Anmeldenummer: **14824376.9**

(22) Anmeldetag: **19.12.2014**

(86) Internationale Anmeldenummer:
**PCT/EP2014/003442**

(87) Internationale Veröffentlichungsnummer:
**WO 2015/090609 (25.06.2015 Gazette 2015/25)**

(54) **SENSORANORDNUNG SOWIE VERFAHREN ZUR ERMITTLUNG WENIGSTENS EINES PHYSIKALISCHEN PARAMETERS**

SENSOR ARRANGEMENT AND METHOD FOR DETECTING AT LEAST ONE PHYSICAL PARAMETER

ENSEMBLE DE DÉTECTION ET PROCÉDÉ POUR MESURER AU MOINS UN PARAMÈTRE PHYSIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.12.2013 DE 102013226887**
**23.05.2014 DE 102014007491**

(43) Veröffentlichungstag der Anmeldung:
**26.10.2016 Patentblatt 2016/43**

(73) Patentinhaber: **Reime, Gerd**
**77815 Bühl (DE)**

(72) Erfinder: **Reime, Gerd**
**77815 Bühl (DE)**

(74) Vertreter: **Reinhardt, Harry**
**RPK Patentanwälte**
**Reinhardt, Pohlmann und Kaufmann**
**Partnerschaft mbB**
**Grünstraße 1**
**75172 Pforzheim (DE)**

(56) Entgegenhaltungen:
**WO-A2-2012/104086     US-A- 5 045 789**
**US-A1- 2007 126 420     US-A1- 2012 206 138**

• **RICK ZARR: "Redefining inductive sensing", ELECTRONIC DESIGN, 13. Mai 2013 (2013-05-13), XP055173520, Gefunden im Internet: URL:http://www.penton.com/digitaleditions/ ed/ed120513_de.pdf> [gefunden am 2015-03-04]**

**EP 3 084 408 B1**

**Beschreibung**

Gebiet der Erfindung

Die Erfindung betrifft eine Sensoranordnung sowie ein Verfahren zur induktiven oder kapazitiven Detektion wenigstens eines Targets durch Ermittlung wenigstens eines physikalischen Parameters nach dem Oberbegriff der Ansprüche 1 und 9.

Stand der Technik

Aus dem Stand der Technik sind verschiedenste Verfahren zur Ermittlung wenigstens eines physikalischen Parameters mittels einer Sensoreinheit bekannt. Diesen Messverfahren ist häufig eine Temperaturabhängigkeit gemeinsam, was im Folgenden anhand induktiver Messsysteme erläutert wird, wenngleich diese Aussagen auch auf beliebige andere Messprinzipien zutreffen wie z.B. kapazitive, resistive, optische oder chemische Messsysteme, sofern der physikalische Messwert in einen elektrischen Wert umgewandelt wird.

Aus der dem Oberbegriff des Anspruches 1 zugrunde liegenden WO 2012/104086 A1 ist ein Verfahren zur Ortung metallischer oder Metall enthaltender Objekte und Materialien bekannt, bei dem Ströme in mindestens zwei Sendespulen so zueinander geregelt werden, dass ein von wenigstens einer Empfangsspule empfangenes Empfangssignal oder Durchschnittswerte von aus dem Empfangssignal generierten Demodulationsphasen zueinander kontinuierlich auch bei Metalleinfluss zu Null geregelt werden. Dabei werden die Regelwerte wenigstens bei 0° und bei 90° als Werte erfasst und so miteinander verrechnet, dass eine exakte Analyse der im Detektionsbereich befindlichen metallischen Gegenstände erreicht wird. Damit ist dort ein induktiver Sensor mit einer Rückkopplung offenbart, die eine Nullmessung bewirkt, wobei die Information im Regelwert enthalten ist, aus dem mittels einer Regeleinheit ein Rückkopplungssignal bestimmt wird. Mit diesem Verfahren kann ein metallischer Gegenstand zwar analysiert werden, jedoch können Bewegungen des Gegenstands nicht eindeutig in eine bestimmte Messrichtung erkannt werden.

RICK ZARR, "Redefining inductive sensing", ELECTRONIC DESIGN, (20130513), URL: http://www.penton.com/digitaleditions/ed/ed120513_de.pdf, (20150304), XP055173520 [I] 1-15 16-19 zeigt ebenfalls einen induktiver Sensor mit einer Rückkopplung, die eine Nullmessung bewirkt, wobei die Information im Regelwert enthalten ist, aus dem mittels einer Regeleinheit ein Rückkopplungssignal bestimmt wird.

Die deutsche Patentanmeldung DE 10 2012 001 202 A1 beschreibt einen Sensor mit einer Spulenanordnung, bei der die normalerweise kreisförmigen Windungen einer Spule in Mäanderform ausgebildet sind. Zwei sendende Spulen und eine Empfangsspule wirken miteinander in der Art, dass das empfangene Signal zu Null wird. Dabei ist vorzugsweise oberhalb und unterhalb der Empfangsspule je eine Sendespule angeordnet. Diese haben zur Empfangsspule hin leicht unterschiedliche Rotationswinkel, so dass über die Verteilung der Sendeströme das Signal in der Empfangsspule zu Null geregelt werden kann.

Aufgabe der Erfindung

Hiervon ausgehend liegt der vorliegenden Erfindung die Aufgabe zugrunde, eine Sensoranordnung und ein Verfahren zu schaffen, bei denen eindeutig auf im Ausgangssignal der Sensoranordnung enthaltene Werte eines physikalischen Parameters in einem Detektionsbereich geschlossen werden kann.

Diese Aufgabe wird durch eine Sensoranordnung mit den Merkmalen des Anspruches 1 sowie durch ein Verfahren zur induktiven oder kapazitiven Detektion eines Targets durch Ermittlung wenigstens eines physikalischen Parameters mit den Merkmalen des Anspruches 9 gelöst.

Die Erfindung geht von Überlegungen aus, die im Folgenden am Beispiel eines induktiven Annäherungssensors erläutert werden, wenngleich das Verfahren auch für beliebige andere Messprinzipien verwendet werden kann wie z.B. kapazitive Messsysteme, sofern der physikalische Messwert in einen elektrischen Wert umgewandelt wird. In der Regel sind elektrische Werte, die ein solcher Sensor liefert sehr klein, so dass eine Verstärkung oder entsprechende Signalaufbereitung erfolgt, bevor diese Signale ausgewertet werden können. Heutige A/D Wandler in Mikroprozessoren sind zwar schon sehr empfindlich, um ein analoges Signal in ein digitales Signal umzusetzen, jedoch entstehen bei einigen Sensoren so kleine Wertänderungen, die noch erfasst werden müssen, so dass auch ein solcher A/D Wandler überfordert ist. Die Erfindung geht nun davon aus, dass so ein kleines Signal mit einem ebenso kleinen, aber vollständig digital erzeugten Signal zu Null kompensiert werden kann. Eine Verstärkung dieses "Nullsignals" kann nun beliebig hoch verstärkt werden und dem A/D Wandler des Mikroprozessors zugeführt werden. Wird dieses Nullsignal durch eine geschlossene Regelung ständig auf Null gehalten, haben äußere Einflüsse und dadurch hervorgerufene Verstärkungsänderungen im System keinen Einfluss mehr auf den Regelwert

Im Wesentlichen liegt der Erfindung dabei die Erkenntnis zugrunde, dass in dem im Empfangspfad ermittelten Signal gleichzeitig Informationen über den physikalischen Parameter und im Ausführungsbeispiel über die Form und/oder Legierung des Targets bzw. Größe der Fläche des Targets im Detektionsbereich des Spulensystems enthalten sind.

Grundsätzlich ist in der Abweichung des Regelwerts auch eine Information über den physikalischen Parameter wie z.B. über seinen Abstand von der Sensoranordnung enthalten. Diese Information liegt aber nicht getrennt von anderen Informationen über den physikalischen Parameter vor. Im Falle der Bewegung oder Position eines Targets sind insofern die Informationen über den Abstand von der Sensoranordnung mit Informationen über eine Bewegung des Targets quer zum Abstand überlagert. Bewegung oder Position des Targets sind durch die Formänderung und/oder Legierungsänderung unabhängig vom Abstand des Targets zum Spulensystem bestimmbar. Werden diese Informationen anspruchsgemäß aufbereitet, lassen sich dadurch die gewünschten weiteren Informationen über den physikalischen Parameter differenziert entnehmen. Wie aus dem Stand der Technik bekannt, erfolgt unter Verwendung von Mitteln zur Signalaufbereitung eine kontinuierliche Regelung des Signals im Empfangspfad in einem geschlossenen Regelkreis, sodass das Empfangssignal immer zu "Null" geregelt wird. Damit führt eine Veränderung im Detektionsbereich des Sende-/Empfangsspulensystems grundsätzlich zu einer Änderung der Regelsignale. Dem Regelsignal ist damit also eine Abweichung vom ausgeregelten Zustand als Information zur Detektion des physikalischen Parameters wie z.B. der Position des Targets immanent.

Werden nach entsprechender Verrechnung der Regelgrößen deren Abweichung, ausgehend von einem ausgeregelten Ausgangszustand, in einer Vierquadrantendarstellung in Form einer Vektoranalyse in einem Phasenraum des Regelsignals aufgetragen, lässt sich erfindungsgemäß feststellen, dass bei einer Vierquadrantendarstellung der Abstand des Targets von der Sensoreinheit in Richtung des Abstands aufgrund eines Betrags eines gedachten Vektors ermittelt wird, wobei der Vektor vom Ursprung des Koordinatensystems, der dem ausgeregelten Zustand entspricht, zu einem Messpunkt führt, und/oder wenigstens eine der Größen umfassend eine Position des Targets, eine quer zur Richtung des Abstands erfolgende Bewegung des Targets, eine Materialeigenschaft des Targets, eine Form des Targets, eine Größe der Fläche des Targets aufgrund eines Winkels des gedachten Vektors ermittelt wird. Im Falle der vorzugsweise durchgeführten Detektion der Position eines Targets in einer Messrichtung ist der Winkel des gedachten Vektors zur horizontalen Achse ein Maß für die Bewegung des Targets in Messrichtung, während der Betrag des gedachten Vektors ein Maß für den Abstand des Targets normal zur Messrichtung ist. Damit kann auf die Bewegung/Position des Targets entlang der Messrichtung getrennt vom Abstand/Bewegung des Targets normal zur Messrichtung oder je nach Target auf die Legierung und die Form des Targets geschlossen werden. Dies hat den Vorteil, dass zum Beispiel bei rotierenden Wellen und anderen Rotationskörpern mit einer konischen, rotationssymmetrischen Form eine Bewegung entlang der Rotationsachse gesondert von quer zu dieser Rotationsachse erfolgenden Bewegungen erfasst werden kann. Damit lassen sich Abstände und Toleranzen aus dem Messergebnis ausblenden, solange sich das Target im Detektionsbereich des Sende-/Empfangsspulensystems befindet.

Als Messrichtung kommen vorzugsweise sämtliche Richtungen von Koordinatenmesssystemen in Betracht. Das Target kann dazu kreisbogenförmig oder auch rotationssymmetrisch kegelförmig aufgebaut sein und/oder an den Oberflächen eines Körpers angebracht werden, dessen Bewegung erfasst werden soll. Grundsätzlich ist jede beliebige Form oder Zusammensetzung verwendbar, solange eine Änderung des Targets in Messrichtung eine Wirkung auf ein Spulensystem ausübt.

Bei Rotationskörpern besteht zudem die Möglichkeit, entweder mit mehreren Targets, die hinsichtlich Ihrer Winkellage am Rotationskörper versetzt aufgebracht sind, oder mit mehreren Sende-/Empfangsspulensystemen, die einem Target zugeordnet sind und geschaltet werden, eine Beobachtung des Rotationskörpers im gesamten Winkelbereich vorzunehmen.

Werden mehrere Targets vorgesehen, können diese unterschiedliche Resonanzfrequenzen aufweisen. Mit anderen Worten werden die einzelnen Targets so ausgebildet, dass sie die Signatur im Vektorplot so beeinflussen, dass ihre Bewegung eindeutig auswertbar ist. Vorzugsweise verjüngen sich die Targets entlang der Messrichtung, wobei die Verjüngungen der Targets vorzugsweise gegenläufig angeordnet sind. Dies führt dazu, dass die induktive Signatur bei Bewegung des Targets in der Vierquadrantendarstellung eine größere Spur hinterlässt, die zur Auswertung von Bewegung und Abstand des Targets zum Sende-/ Empfangsspulensystem besser genutzt werden kann.

Unter einem Nullsignal kann ein Signal verstanden werden, das außer einem eventuell vorhandenen Rauschen keinerlei Informationen enthält. Insbesondere kann darunter verstanden werden, dass im Falle von Wechselspannungen keine Phase und auch keine Amplitude auftreten. Insbesondere kann in diesem Sinne auch eine Gleichspannung und/oder eine verrauschte Gleichspannung als Nullsignal verstanden werden. Als Sonderfall könnte ein 0 Volt aufweisendes Signal als Nullsignal verstanden werden.

Weitere Vorteile ergeben sich aus den Unteransprüchen und der nachfolgenden Beschreibung bevorzugter Ausführungsbeispiele.

Kurzbeschreibung der Figuren

Im Folgenden wird die Erfindung anhand eines Ausführungsbeispiels näher erläutert. Es zeigen:

Fig. 1 ein schematisches Blockschaltbild der Systemkomponenten,

Fig. 2 ein Ablaufdiagramm für die Vorgehensweise bei der Messwertauswertung,

Fig. 3 eine dreidimensionale Seitenansicht eines Targets mit zugeordnetem Sende-/ Empfangsspulensystem,

Fig. 4a, 4b eine Draufsicht auf die Darstellung gemäß Fig. 3 bei Verschiebung des Targets entlang der n-Achse und bei Verschiebung des Targets entlang der Messachse m,

Fig. 5, 6 eine Vierquadrantendarstellung der Abweichungen der Regelsignale,

Fig. 7, 8 Draufsicht und Seitenansicht auf Target und Sende-/Empfangsspulenanordnung bei einem rotierenden Target,

Fig. 9a, 9b Darstellungen gemäß Fig. 7 in einem Ausführungsbeispiel mit zwei Sende/Empfangsspulensystemen,

Fig. 10 Signalverläufe der beiden Sende-/Empfangsspulensysteme gemäß Fig. 9a, 9b,

Fig. 11, 12 verschiedene Ausführungsformen der Sensoranordnung zur Erfassung der Rotation einer Welle,

Fig. 13 eine schematische Schaltung eines Sende-/Empfangsspulensystems mit getaktet betriebener Sendespule und Empfangsspule,

Fig. 14a, 14b schematische Schaltungen alternativer Sende-/Empfangsspulensysteme,

Fig. 15, 16 verschiedene Ausführungsbeispiele von Anordnungen eines Targets über einem Sende-/Empfangsspulensystem in Draufsicht,

Fig. 15a, 16a aufgrund der jeweiligen Targets erhaltene induktive Signaturen in einer Vierquadrantendarstellung der Regelabweichungen Δx, Δy,

Fig. 17 Signalverläufe im Rahmen der Regelung des Empfangssignals aus dem Sende-/Empfangsspulensystem zu Null,

Fig. 18 eine schematische Darstellung betreffend die Signalverarbeitung,

Ausführliche Beschreibung bevorzugter Ausführungsbeispiele

Die Erfindung wird jetzt beispielhaft unter Bezug auf die beigefügten Zeichnungen näher erläutert. Allerdings handelt es sich bei den Ausführungsbeispielen nur um Beispiele, die nicht das erfinderische Konzept auf eine bestimmte Anordnung beschränken sollen. Bevor die Erfindung im Detail beschrieben wird, ist darauf hinzuweisen, dass sie nicht auf die jeweiligen Bauteile der Vorrichtung sowie die jeweiligen Verfahrensschritte beschränkt ist, da diese Bauteile und Verfahren variieren können. Die hier verwendeten Begriffe sind lediglich dafür bestimmt, besondere Ausführungsformen zu beschreiben und werden nicht einschränkend verwendet. Wenn zudem in der Beschreibung oder in den Ansprüchen die Einzahl oder unbestimmte Artikel verwendet werden, bezieht sich dies auch auf die Mehrzahl dieser Elemente, solange nicht der Gesamtzusammenhang eindeutig etwas Anderes deutlich macht.

Dabei wird die Erfindung im Folgenden am Beispiel eines induktiven Annäherungssensors erläutert, wenngleich das Verfahren auch für kapazitive Messprinzipien verwendet werden kann, sofern der physikalische Messwert in einen elektrischen Wert umgewandelt wird. Insofern wäre in den Figuren lediglich das Sende-/Empfangsspulensystem 1.1 durch eine entsprechend anders arbeitende Sensoreinheit zu ersetzen.

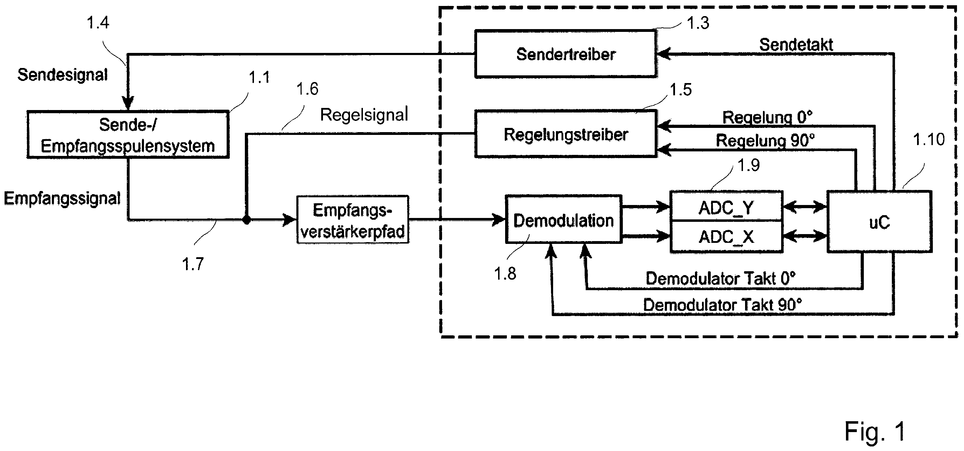

Der grundsätzliche Aufbau der induktiven Sensoranordnung ist in dem Blockschaltbild gemäß Fig. 1 dargestellt. Dieser Grundaufbau entspricht im Wesentlichen dem Aufbau, wie er aus der WO 2012/104 086 A1 bekannt ist.

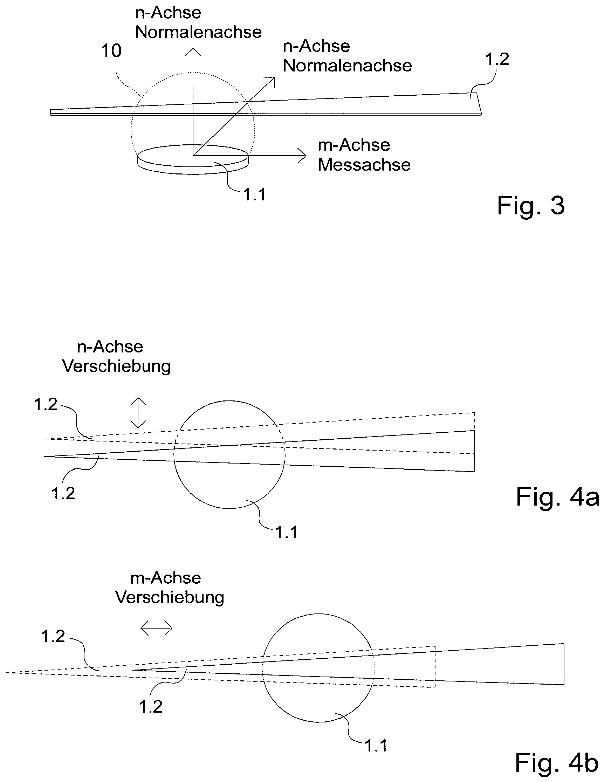

Bei einem induktiven Annäherungssensor ist zur induktiven oder kapazitiven Detektion wenigstens eines Targets 1.2, das in den Figuren 3 bis 9b, 11,12 dargestellt ist, durch Ermittlung wenigstens eines physikalischen Parameters wenigstens ein Sende-/Empfangsspulensystem 1.1 als Sensoreinheit und damit Teil der Sensoranordnung vorgesehen. Das Target 1.2 wirkt mit der Sensoreinheit in der Sensoranordnung zusammen. Im Ausführungsbeispiel werden z.B. Position oder Materialbeschaffenheit des Targets detektiert. Das Sende-/ Empfangsspulensystem 1.1 bildet einen Detektionsbereich 10 aus, wie er in Fig. 3 dargestellt ist. Ein Sendetreiber 1.3 speist eine periodische Anregung als Sendesignal 1.4 vorzugsweise mit einer Sendefrequenz von z.B. 200 kHz in die Sendespule des Sende-/ Empfangsspulensystems 1.1 ein. Das Sendesignal zum Sende-/ Empfangsspulensystem kann z.B. ein Reckeck- oder Sinussignal sein. Das Sende-/ Empfangsspulensystem ist geometrisch so geformt und/oder so kalibriert, dass das vom Sendesignal 1.4 ausgehende Empfangssignal ohne Target im Detektionsbereich Null ist. Im Ausführungsbeispiel der Fig. 1 bewirkt ein Target im Detektionsbereich 10 eine induktive Wirkung eines Signals ungleich Null im Empfangspfad 1.7 des Sende-/ Empfangsspulensystems 1.1, wobei dieses Signal eine bestimmte Amplitude und Phase aufweist.

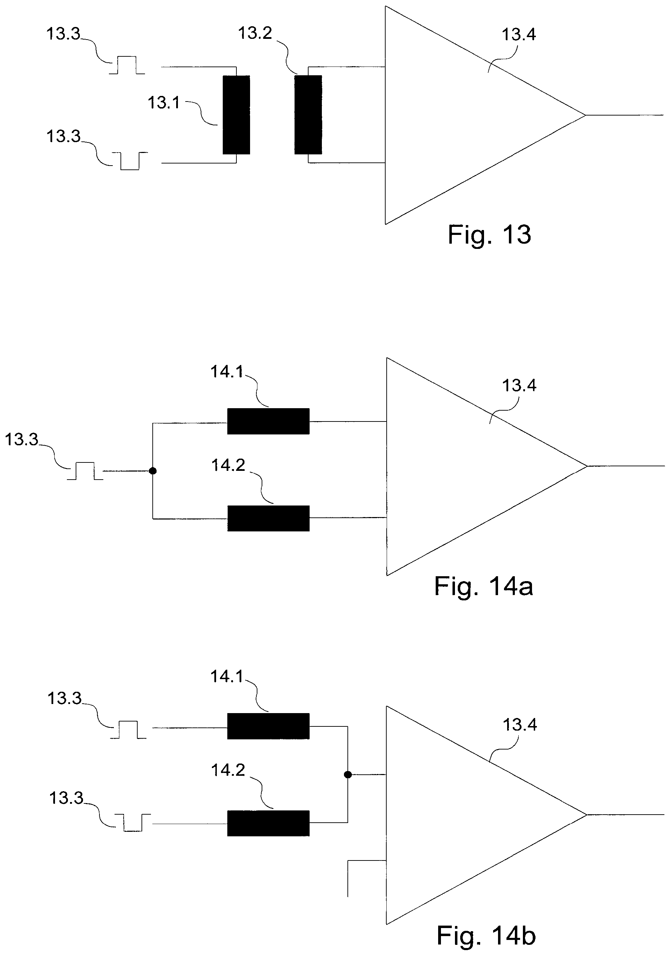

Der Aufbau von Sende- und Empfangsspule kann z.B. wie in der deutschen Patentanmeldung DE 10 2012 001 202 A1 sein. Im Wesentlichen sind dabei die normalerweise kreisförmigen Windungen einer Spule so in Mäanderform ausgebildet, dass das empfangene Signal zu Null wird. Dabei ist die Sendespule zur Empfangsspule hin leicht im Rotationswinkel versetzt, so dass über die Verteilung der Sendeströme das Signal in der Empfangsspule zu Null geregelt werden kann. Dieses Spulensystem besteht somit aus mindestens zwei unabhängigen Spulenteilen. Auf die konkrete Schaltung der Sende-/Empfangsspulensysteme wird unten im Zusammenhang mit den Fig. 13, 14a und 14b nochmals eingegangen.

Hinsichtlich Amplitude und Phase als auch hinsichtlich des konkreten Aufbaus des Sende/ Empfangsspulensystems mit Sendespule und Empfangsspule wird auf die Erläuterung in der WO 2012/104 086 A1 verwiesen. Zusammengefasst ergibt sich daraus, dass das Sendesignal 1.4 durch den Sendetakt periodisch getaktet wird, sodass ein Target 1.2 im Detektionsbereich 10 eine Amplitude und Phase bewirkt, die durch Demodulation 1.8 bei 0° (und 180°) bzw. bei 90° (und 270°) bestimmt werden kann. In der Demodulation werden die Amplitudenanteile im Ausführungsbeispiel den beiden Taktphasen des Sendetakts zugeordnet. Dabei ist es nicht wichtig, wo genau die Demodulationsphasen sich zum Sendetakt befinden. sondern nur dass die Demodulationsphasen um 90° zueinander versetzt sind. Diese aus den Demodulationsphasen gewonnenen DC-Signale werden zum Beispiel mithilfe eines Analog-Digital-wandlers 1.9 gemessen und an den Mikrocontroller 1.10 übermittelt. Der Mikrocontroller 1.10 steuert den Regelungstreiber 1.5 im geschlossenen Regelkreis so an, dass im Empfangspfad 1.7 ein Regelsignal 1.6 so eingespeist wird, dass das Signal im Empfangspfad 1.7 Null ist. Das Signal im Empfangspfad 1.7 kann vor der Demodulation nahezu beliebig verstärkt werden, da grundsätzlich nur die Abweichung zum ausgeregelten Zustand im Signal vorhanden ist..

Die Signalaufbereitung und Interpretation der Messwerte sowie die Regelung wird durch den Mikrocontroller 1.10 umgesetzt. Sendetreiber 1.3, Regelungstreiber 1.5, Demodulation 1.8 und Analog-Digitalwandler 1.9 können extern aufgebaut sein oder mit einem geeigneten Mikrocontroller mit entsprechender Peripherie intern im Mikrocontroller realisiert sein. Die Komponenten, die in dem gestrichelten Rahmen in Fig. 1 dargestellt sind, können insofern Bestandteil des Mikrocontrollers sein.

Der Regelungstreiber 1.5 sorgt mit seinem Regelsignal 1.6 grundsätzlich dafür, dass ein Signal ungleich Null, das im Empfangspfad zum Beispiel durch ein Target 1.2 ausgelöst wird, zu Null ausgeregelt wird. Das Regelsignal bildet demnach in seiner Phase und Amplitude exakt die elektromagnetische Wirkung des Targets 1.2 auf das Sende-/Empfangsspulensystem ab. Dem zur Erzielung eines ausgeregelten Zustands erforderlichen Regelsignal 1.6 ist dabei eine Abweichung $\Delta x$, $\Delta y$ von einem ausgeregelten Ausgangszustand als Information zur Detektion der Position des Targets immanent. Diese Information kann noch entsprechend ausgewertet werden.

Gemäß Fig. 3 und 4a, 4b wird dazu als Messgröße, die auf die induktive Signatur wirkt, also darauf wie sich die Abweichungen $\Delta x$ und $\Delta y$ zum Beispiel in einer Vierquadrantendarstellung darstellen, z.B. eine sich entlang einer Messrichtung m veränderliche Form eines Targets 1.2 verwendet. Kommt es nur auf den Abstand zur Messanordnung an, kann das Target auch in bekannter Weise homogen ausgebildet sein.

In Fig. 3, 4a, 4b handelt es sich um ein sich in einer oder gegen eine bestimmte Messrichtung m verjüngendes Target 1.2. Anstelle der Verjüngung des Targets sind auch andere Formen und inhomogene Legierungen oder Materialkombinationen denkbar, die sich auf die induktive Signatur auswirken. Zum Beispiel kann das Target auch stufenweise seine Form in Messrichtung m ändern. Denkbar ist ebenso, dass sich die Zusammensetzung des Targets 1.2 entlang der Messrichtung m ändert, indem zum Beispiel eine inhomogene Legierung verwendet wird. Wesentlich ist lediglich, dass wie im Ausführungsbeispiel der Fig. 1 das aus wenigstens zwei Spulen aufgebaute Sende/ Empfangsspulensystem 1.1 einen Detektionsbereich 10 aufweist und so beschaltet ist, dass am Ausgang des Sende-/ Empfangsspulensystems 1.1 ohne Metalleinfluss im Detektionsbereich das Ausgangssignal ein Nullsignal ist. Befindet sich im Detektionsbereich 10 ein Target 1.2, ist das Ausgangssignal ein Signal ungleich Null, das eine bestimmte Amplitude und Phase aufweist. In einem geschlossenen Regelkreis wird dieses Signal ungleich Null mittels eines Regelsignals 1.6 auch bei Vorhandensein des Targets 1.2 im Detektionsbereich 10 zur Erzielung eines ausgeregelten Zustands zu Null ausgeregelt und aufbereitet. Dabei ist dem Regelsignal 1.6 eine Abweichung $\Delta x$, $\Delta y$ des Regelsignals vom ausgeregelten Zustand als Abstandsinformation zur Detektion der Position des Targets 1.2 immanent. Mit anderen Worten sind in den Regelabweichungen nicht eindeutig zuordenbare Informationen über den physikalischen Parameter enthalten. Diese Abweichungen $\Delta x$, $\Delta y$ des Regelsignals werden in einem x-, y-Koordinatensystem in einer Vierquadrantendarstellung in Form einer Vektoranalyse in einem Phasenraum des Regelsignals aufgetragen, wobei der Ursprung 2.7 des x-, y-Koordinatensystems dem ausgeregelten Ausgangszustand des Sende-/ Empfangsspulensystems 1.1 entspricht, in dem die Regelsignale Null sind bzw. zu Null kalibriert sind. Die Änderung im Regelsignal, auf die weiter unten noch näher eingegangen wird, führt dazu, dass in der Vierquadrantendarstellung der Abweichung $\Delta x$ und der Abweichung $\Delta y$ des Regelsignals aufgrund eines Winkels eines gedachten Vektors 2.6 zur x-Achse des x-, y-Koordinatensystems, welcher Vektor vom Ursprung 2.7 zu einem Messpunkt 2.5 führt, die Bewegung des Targets 1.2 in Messrichtung m ermittelt wird, also ein Maß für den Wert des physikalischen Parameters entlang einer Richtung oder Skala. Ferner wird aufgrund des Betrags des gedachten Vektors 2.6 der Abstand des Targets 1.2 normal zur Messrichtung m, also ein Maß für den Wert des physikalischen Parameters entlang einer weiteren Richtung oder Skala ermittelt.

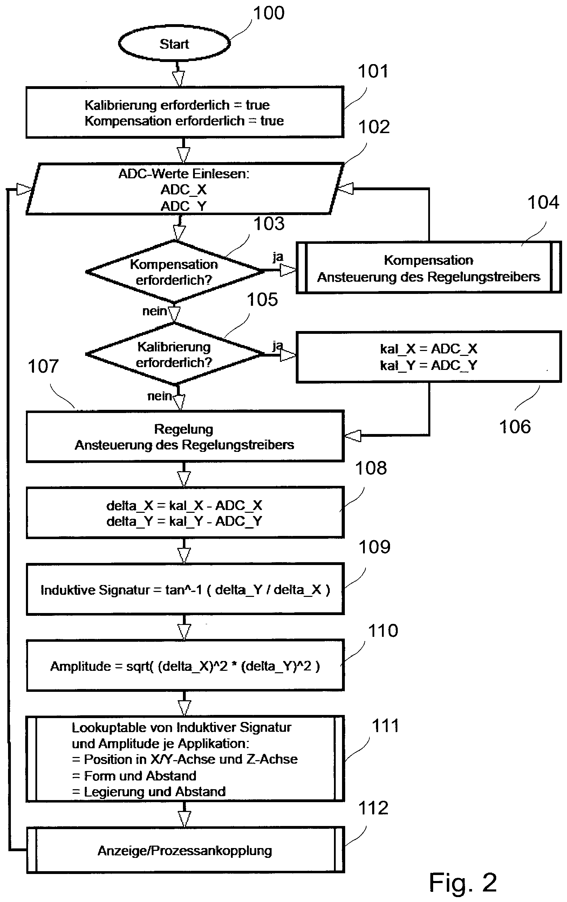

Bevor hierauf näher eingegangen wird, wird zunächst der Verfahrensablauf anhand des Ablaufdiagramms gemäß Fig. 2 erläutert. Nach dem Start des Systems in Schritt 100 erfolgt zunächst eine Kalibrierung und gegebenenfalls Kompensierung gemäß Schritt 101. Dazu werden zunächst in Schritt 102 die Werte des Analog-Digitalwandlers 1.9 eingelesen. Abhängig von den gemessenen Werten wird in Schritt 103 überprüft, ob eine Kompensation erforderlich ist. Der Mikrocontroller 1.10 gibt insofern für den Regelungstreiber 1.5 in Schritt 104 Werte vor, um eventuelle Toleranzen des Systems auszugleichen. Dieser Vorgang wird für beide Phasen des Sendetakts so lange durchgeführt, bis die Werte der AD-Wandlung einen vorgegebenen Wert, zum Beispiel die Mitte des AD-Wandlerdynamikbereichs erreichen. In der Regel dauert dieser Vorgang nur wenige Millisekunden. Danach sind die Toleranzen des Spulensystems und eventuelle Umgebungseinflüsse kompensiert. Ergibt sich dann in Schritt 105, dass eine Kalibrierung erforderlich ist, werden in Schritt 106 die gemessenen Werte der AD-Wandlung gespeichert und dienen fortan als kalibrierter Nullpunkt des Systems.

Jetzt beginnt die eigentliche Messung, das heißt, es wird die Einwirkung des Targets 1.2 auf das induktive System gemessen. Diese Einwirkung führt zur Abweichung Δx und Δy vom kalibrierten Nullpunkt gemäß Schritt 108. Aus diesen Abweichungen lässt sich die induktive Signatur ermitteln, das heißt die Position bzw. Bewegung des Targets 1.2 in Messrichtung m gemäß Schritt 109 sowie der Abstand des Targets 1.2 vom ausgeregelten Zustand normal zur Messrichtung m gemäß Schritt 110. Diese Werte können in einem Look up Table, einer Wertetabelle gemäß Schritt 111 kreuzreferenziert werden, um zum Beispiel die Legierung des Materials zu bestimmen. Sie dienen aber auch zur Bestimmung von Position, Form und Abstand des Targets 1.2 in den Messrichtungen. Die so ermittelten Werte können dann angezeigt werden gemäß Schritt 112. Das Verfahren läuft kontinuierlich, das heißt nach Schritt 112 springt das System zu Schritt 102. Diese kontinuierliche Regelung endet erst bei Außerbetriebnahme des Systems.

Zurück in Fig. 3 wird ein Aufbau mit einem keilförmigen, sich verjüngenden Target und einem Sende-/ Empfangsspulensystem 1.1 gezeigt. Das Koordinatensystem m, n, n wird für diese Anmeldung so verwendet, dass ausgehend vom Sende-/ Empfangsspulensystem 1.1 die m-Achse eine Positionsänderung zu diesem System entlang einer Messachse definiert, während eine Positionsänderung entlang einer der n-Achsen eine zu dieser Messachse normal verlaufende Positionsänderung eines Targets ist. Eine Bewegung entlang einer der n-Achsen verändert also den Abstand des Targets 1.2 zum Sende-/ Empfangsspulensystem. Die beiden n-Achsen stehen insofern normal zur m-Achse. Fig. 3 zeigt eine dreidimensionale Seitenansicht auf ein derartiges System, Fig. 4a, 4b eine Draufsicht. Eine Bewegung des Targets 1.2 in die gestrichelte Darstellung in Fig. 4a ist insofern eine Bewegung entlang der n-Achse und zeigt z.B. gegenüber dem Sende-/Empfangsspulensystem 1.1. eine Verschiebung quer zur m-Achse. Eine Bewegung gemäß Fig. 4b ist hingegen eine Bewegung in Richtung der m-Achse, die vorzugsweise die Messrichtung ist.

Das Target 1.2 ist in den Figuren nur schematisch dargestellt. Innerhalb bestimmter Grenzen ist das Messsystem für Messungen entlang der Messrichtung, der m-Achse, unabhängig gegenüber Toleranzen auf der n-Achse. Wird statt eines keilförmigen ein rotationssymmetrisches, kegelförmiges Target verwendet, ist das System außerdem vollkommen unempfindlich gegenüber Rotationsabweichungen um die m-Achse, während gleichwohl Änderungen entlang der m-Achse gemessen werden können.

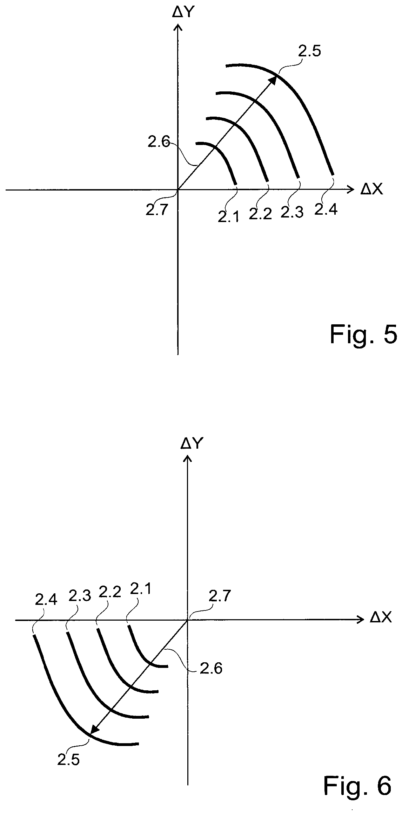

Dies wird deutlich an Hand der Fig. 5 und 6, die die Darstellung der Signale in einer Vierquadrantendarstellung zeigen. Die Messwertkurven 2.1 bis 2.4 ergeben sich durch ein Durchfahren eines keilförmigen Targets durch den Detektionsbereich 10 entlang der m-Achse bei vier verschiedenen Abständen zur m-Achse. Es ist erkennbar, dass mit kleiner werdendem Abstand sich die Kurve von der Position gemäß Messwertkurve 2.1 bis zur Messwertkurve 2.4 vom Ursprung 2.7 entfernt. Die Kurve 2.1 zeigt also den Signalverlauf bei großem Abstand des Targets zum Sensor, die Kurve 2.4 den Signalverlauf bei geringem Abstand des Targets zum Sensor. Gleichzeitig ist zu erkennen, dass die Kurven dabei skaliert werden. Bei einer Verschiebung des Targets 1.2 in Messrichtung m ohne Verschiebung in einer Richtung normal zur Messrichtung m wie zum Beispiel in Richtung der n-Achse verändert sich die Richtung eines gedachten Vektors 2.6 bzw. der Winkel zwischen der x-Achse und einem gedachten Vektor 2.6 vom Ursprung 2.7 zum Messpunkt 2.5. Somit stellt die Richtung des Vektors ausschließlich ein Maß für die Bewegung des Targets 1.2 in Messrichtung m dar. In der Praxis bedeutet dies z.B. dass ein Target mit einer Länge von ca. 50 mm und einer Verjüngung von 7 mm auf 2 mm eine Winkelveränderung des Vektors zur x-Achse von 21,5° auf 46,2° auslöst.

Bei einer Bewegung normal zur Messrichtung m und damit in n-Richtung ohne Verschiebung entlang der m-Achse verändert sich der Betrag des gedachten Vektors 2.6 vom Ursprung 2.7 zum Messpunkt 2.5. Der Betrag des Vektors beschreibt dabei den Abstand des Targets zum Spulensystem. Die Richtung des Vektors, die die induktive Signatur beschreibt, bleibt jedoch gleich. Damit präsentiert der Betrag des Vektors ausschließlich die Position des Targets, d.h. den Abstand des Targets zum Spulensystem.

Der in Fig. 5 gezeigte Signalverlauf ist nur beispielhaft. Bei Targets unterschiedlicher Materialien oder Formen können Signale auch in anderen Quadranten bzw. mit anderen targetspezifischen Signalverläufen entstehen. So zeigt zum Beispiel Fig.6 eine Darstellung im dritten Quadranten.

Um aus diesen Darstellungen nun Position und Abstand des Targets 1.2 zum Spulensystem zu bestimmen, werden die gemäß Fig. 2 ermittelten Abweichungen Δx, Δy des Regelsignals dahingehend interpretiert, dass in Schritt 108 sich der Betrag des Vektors $B_v$ aus dem quadratischen Mittelwert der Abweichungen zum kalibrierten Nullpunkt ergibt, das heißt zu:

$$B_v = \sqrt{\Delta X^2 + \Delta Y^2}$$

Formel 1

Dieser Betrag des Wertes entspricht dem Abstand des Targets 1.2 zum Spulensystem. Die Position des Targets entlang der m-Achse ergibt sich aus der Richtung des gedachten Vektors 2.6 zu:

$$S_i = \tan^{-1}\left(\frac{\Delta Y}{\Delta X}\right)$$

Formel 2

$S_i$ steht für induktive Signatur und entspricht der Position entlang der-m-Achse. Die Werte $B_v$ und $s_i$ können als Zahlenwerte für weitere Anwendungen verwendet werden. Durch spezielle für die entsprechende Applikation erstellte Algorithmen bzw. eine dafür erstellte Wertetabelle, in der Normwerte von Amplitude und induktiver Signatur gespeichert sind, kann je nach Applikation auf verschiedene Messgrößen gemäß Schritt 111 geschlossen werden. Mögliche Messgrößen sind beispielsweise:

- Position eines Targets entlang der m-Achse und Abstand zur m-Achse
- Legierung und Abstand eines Targets
- Form und Abstand eines Targets

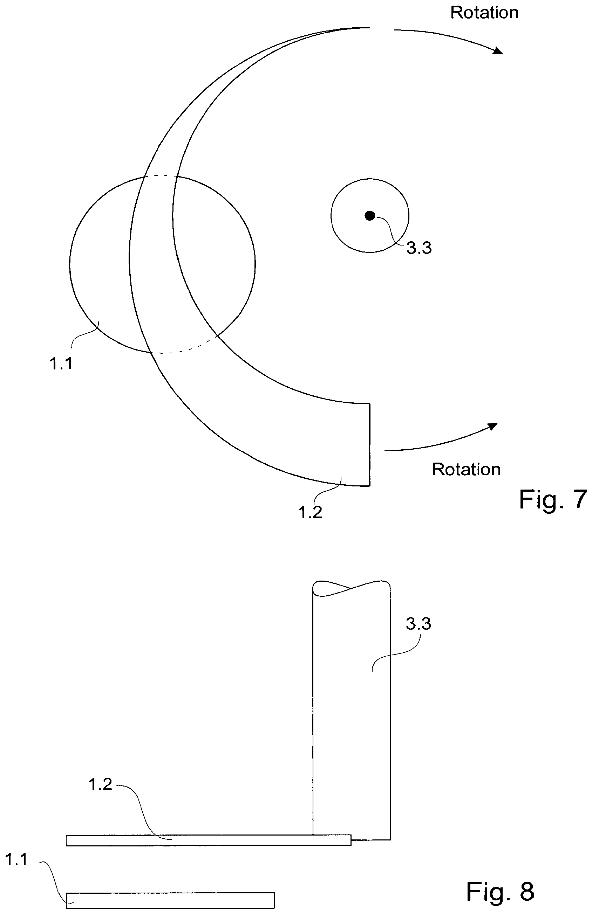

Die erste Messgröße ($S_i$) ist durch die Richtung des gedachten Vektors 2.6 bzw. dessen Winkel zur x-Achse und die zweite Messgröße ($B_v$) durch den Betrag dieses Vektors bestimmt. Der in Fig. 3 dargestellte Aufbau kann auch als rotierendes System gemäß den Figuren 7 und 8 umgesetzt werden. Dabei wird ein sich verjüngendes kreisbogenförmiges Target 1.2 über dem Spulensystem 1.1 um eine Rotationsachse 3.3 rotiert. Innerhalb bestimmter Grenzen ist dieses Messsystem wiederrum unabhängig gegenüber Verschiebungstoleranzen, die parallel und/oder normal zur Rotationsachse 3.3 auftreten.

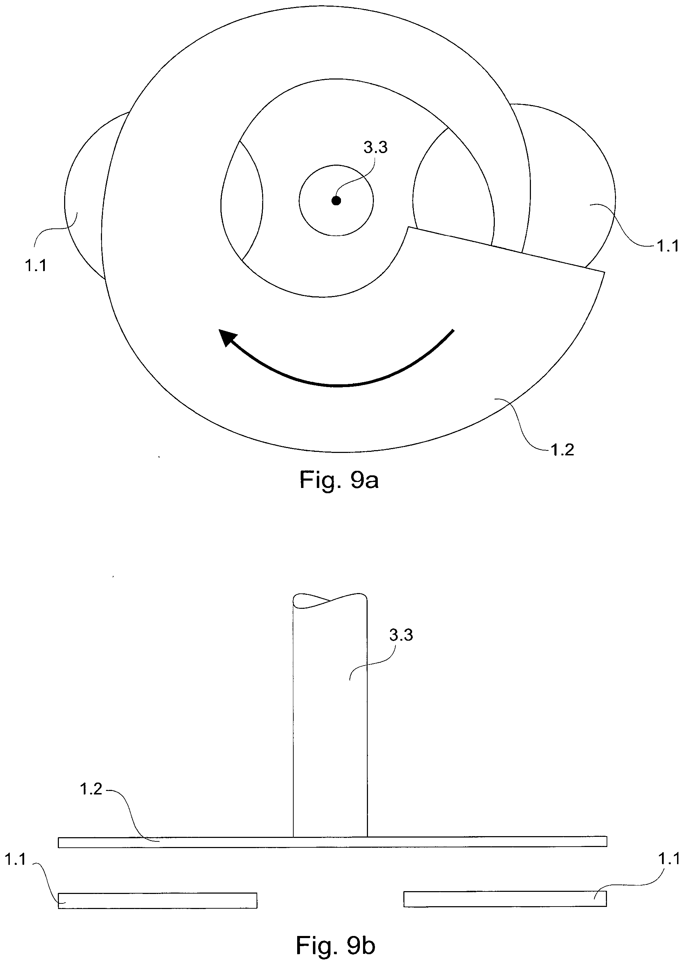

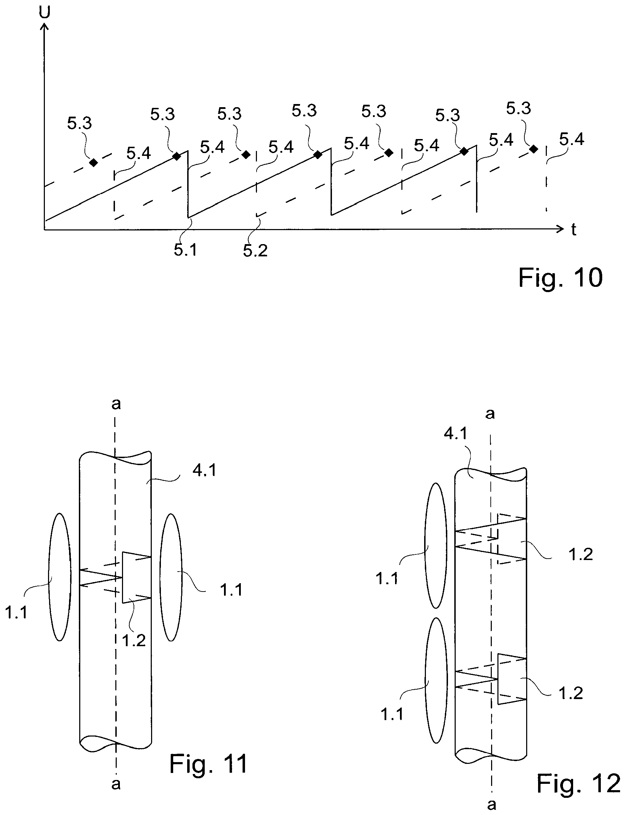

Um Rotationen um 360° in einem solchen Fall lückenlos detektieren zu können, kann das Target 1.2 gemäß Fig. 9a, 9b aufgebaut werden. Dabei schließt das verjüngte Ende des Targets an das andere Ende des Targets an. Dazu können z.B. mindestens zwei Sende-/ Empfangsspulensysteme 1.1 benutzt werden, damit Signalsprünge, die sich am Übergang von Anfang zu Ende des Targets 1.2 ergeben, keine Fehlinterpretationen produzieren können. Die Signale, die beim Messen mit zwei Sende-/Empfangsspulensystemen an unterschiedliche Rotationswinkelpositionen des Targets 1.2 entstehen, sind in Fig. 10 schematisch dargestellt. Ein erstes Sende-/ Empfangsspulensystem erzeugt einen ersten Signalverlauf 5.1 und ein zweites Sende-/ Empfangsspulensystem einen zweiten Signalverlauf 5.2. Bei der Messung kann beim Erreichen eines Umschaltpunktes 5.3 zwischen der Auswertung des ersten und des zweiten Signalverlaufs umgeschaltet werden, um Fehlinterpretationen an den Sprungstellen 5.4 der Signale zu vermeiden. In Fig. 9a, 9b sind die zwei Sende-/ Empfangsspulensysteme 1.1 hinsichtlich der Rotationsachse 3.3 einander gegenüberliegend angeordnet.

Die gesamte Anordnung und das Verfahren können auch zur Messung der Rotation eines Rotationskörpers 4.1 wie einer Welle verwendet werden. Fig. 11 zeigt einen derartigen Aufbau, um die Rotation einer Welle zu messen. Innerhalb bestimmter Grenzen ist auch dieses System unabhängig gegenüber Verschiebungstoleranzen, die parallel und/oder rechtwinklig zur Rotationsachse a-a des Rotationskörpers auftreten, da auch hier die Bewegung in Messrichtung m gesondert von einer Bewegung normal zur Messrichtung n erfasst werden kann.

Um Rotationen um 360° lückenlos detektieren zu können, werden auch hier zwei Sende-/ Empfangsspulensysteme 1.1 benutzt, damit Signalsprünge, die sich am Übergang von Anfang zu Ende des Targets ergeben, keine Fehlinterpretationen hervorrufen können. Im konkreten Ausführungsbeispiel befinden sich die Sende-/ Empfangsspulensysteme diametral einander gegenüberliegend. Das Target 1.2 ist am Umfang des Rotationskörpers 4.1 aufgebracht und erstreckt sich vorzugsweise über den gesamten Umfang des Rotationskörpers und verjüngt sich dabei entlang des Umfangs. Ebenso kann das Target 1.2 eine sich entlang des Umfangs des Rotationskörpers 4.1 veränderliche Form oder Zusammensetzung aufweisen. Durch die beiden Sende-/ Empfangsspulensysteme 1.1 ergibt sich ein Signalverlauf wie in Fig. 10 erläutert.

Um alternativ zu ermöglichen, dass beide Sende-/ Empfangsspulensysteme 1.1 auf nur einer Seite des Rotationskörpers 4.1 angebracht werden können, kann ein Aufbau gemäß Fig. 12 erfolgen. Dabei sind mehrere Targets 1.2 räumlich und hinsichtlich ihrer Winkellage am Rotationskörper 4.1 versetzt aufgebracht. Innerhalb bestimmter Grenzen ist auch dieses Messsystem unabhängig gegenüber Verschiebungstoleranzen die parallel und/oder rechtwinklig zum Rotationskörper auftreten.

Mit diesem System kann auch die Torsion an einem Rotationskörper 4.1 wie einer Welle gemessen werden. Sind nämlich zwei Sende-/ Empfangsspulensysteme an entlang der Rotationsachse verschiedenen Stellen des Rotationskörpers vorgesehen, entsprechen Differenzen in den Signalen der beiden Messsysteme einer Torsion der Welle. Als Messgröße kann auch ein axiales Spiel bzw. ein Verschleiß an einer rotierenden Welle als Rotationskörper ermittelt werden. Diese Messgröße spiegelt sich nämlich im Abstand des Targets 1.2 zum Sende-/ Empfangsspulensystem 1.1 als gesamter Betrag $B_v$ wieder und ist deutlich von der Position des Targets als induktive Signatur $S_i$ getrennt zu erfassen.

Verfahrensgemäß wird die Position eines Targets mit einer induktiven Sensoranordnung mit einem aus wenigstens zwei Spulen aufgebauten Sende-/ Empfangsspulensystem 1.1 mit einem Detektionsbereich 10 erfasst. Das Sende-/ Empfangsspulensystem 1.1 ist so beschaltet oder auch geometrisch so geformt und/oder so kalibriert, dass am Ausgang des Sende-/ Empfangsspulensystems ohne Metalleinfluss im Detektionsbereich 10 das Ausgangssignal ein Nullsignal ist. Bei einem Target 1.2 im Detektionsbereich 10 ist das Ausgangssignal ein Signal ungleich Null, wobei dieses Signal eine bestimmte Amplitude und Phase aufweist. Ein Regelungstreiber 1.5 regelt über einen geschlossenen Regelkreis mit einem auf den Empfangspfad einwirkenden Regelsignal 1.6 das Signal ungleich Null auch bei Vorhandensein des Targets 1.2 im Detektionsbereich 10 zur Erzielung eines ausgeregelten Zustands zu Null aus. Diesem Regelsignal ist eine Abweichung $\Delta x$, $\Delta y$ vom ausgeregelten bzw. kalibrierten Zustand als Abstandsinformation zur Detektion der Position des Targets immanent. Diese Abweichungen $\Delta x$, $\Delta y$ des Regelsignals werden in einer Vierquadrantendarstellung in einem x-, y-Koordinatensystem aufgetragen, dessen Ursprung der ausgeregelte bzw. kalibrierte Zustand ist, also der Zustand, in dem das Regelsignal Null ist. Weist das Target 1.2 eine sich entlang einer Messrichtung m veränderliche Form oder Zusammensetzung auf, wird in der Vierquadrantendarstellung der Abweichungen $\Delta x$ und $\Delta y$ des Regelsignals die Information ausgewertet, wobei aufgrund des Winkels eines gedachten Vektors 2.6 vom Ursprung 2.7 zu einem Messpunkt 2.5 die Bewegung des Targets 1.2 in Messrichtung m ermittelt wird. Aufgrund des Betrags des gedachten Vektors 2.6 wird der Abstand des Targets 1.2 vom Sende-/ Empfangsspulensystem 1.1 normal zur Messrichtung m ermittelt.

Das Sende-/ Empfangsspulensystem 1.1 kann gemäß den Fig. 13, 14a und 14b aufgebaut sein. Im Ausführungsbeispiel der Fig. 13 wird der Sendespule 13.1 das Sendesignal 13.3 im Sendetakt alternierend und invertiert zugeführt. Dieses Sendesignal induziert ein Empfangssignal in der Empfangsspule 13.2, das im nachfolgenden Verstärker 13.4 verstärkt wird und dann in der Demodulation 1.8 gemäß Fig. 1 verarbeitet wird. Eine derartige Anordnung von Sendespule und Empfangsspule ist jedoch nicht unbedingt erforderlich. Gemäß Fig. 14a kann der Sendetakt auch auf die Spulen 14.1 und 14.2 einwirken, die dann gleichzeitig Sende- und Empfangsspule sind. Nähert sich ein Target einer dieser Spulen, so wird das ausgesendete und empfangene magnetische Feld vom Target beeinflusst. Die Spule 14.2 wird dann zur Referenzspule, während z.B. die Spule 14.1 vom Target beeinflusst wird. Dies wird im beschriebenen geschlossenen Regelkreis ausgeregelt, woraus sich dann die für die Detektion des Targets auszuwertenden Regelsignale ergeben. In Fig. 14b werden die Spulen gemäß Fig. 14a mit einem alternierenden und invertierten Sendesignal 13.3 versorgt.

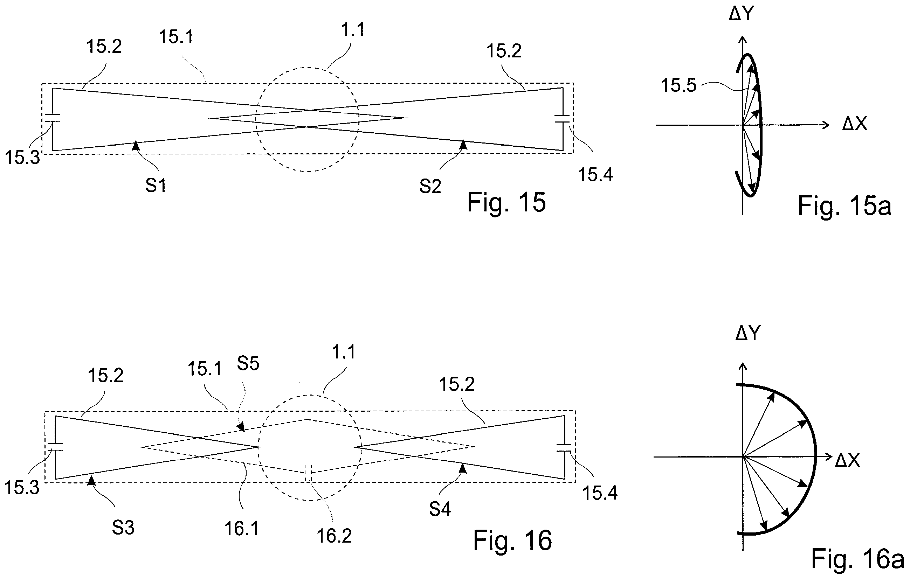

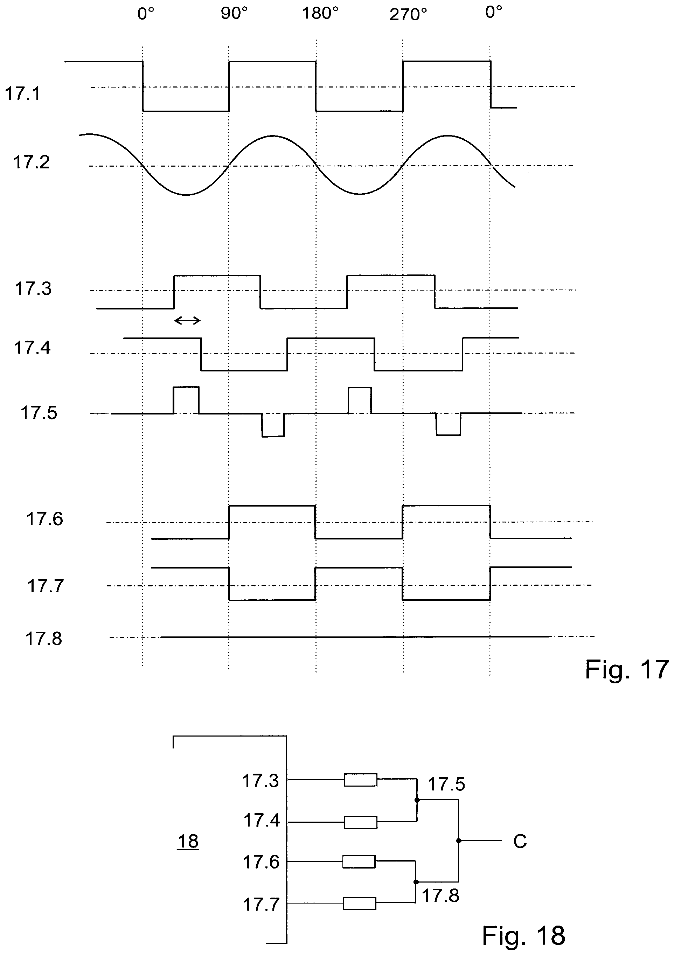

Zur induktiven Detektion der Position des Targets 1.2, das in den Figuren 15 und 16 durch die Targets 15.2, 16.1 gebildet ist, ist das Sende-/ Empfangsspulensystem 1.1 vorgesehen. Ein Sendetreiber speist auch dort ein periodisches Sendesignal 17.1 in die Sendespule des Sende-/ Empfangsspulensystems 1.1 ein. Dieses Sendesignal kann gemäß Fig. 17 ein Rechtecksignal sein, es kann aber auch ein Sinussignal oder ein anderes beliebiges periodisches Signal sein. Das Sende-/ Empfangsspulensystem 1.1 ist geometrisch so geformt und/oder kalibriert, dass das vom Sendesignal ausgehende Empfangssignal 17.2 ohne Target im Detektionsbereich Null ist. Ein Target hingegen bewirkt im Detektionsbereich 10 eine induktive Wirkung eines Signals ungleich Null im Empfangspfad des Sende-/Empfangsspulensystems 1.1, wobei dieses Signal eine bestimmte Amplitude und Phase aufweist.

Eine sich entlang einer Messrichtung m veränderliche Form weisen auch die Targets gemäß den Figuren 15 und 16 auf, wobei diesen Ausführungsbeispielen gemeinsam ist, dass das Target mehrere sich entlang der Messrichtung verjüngende Targets 15.2, 16.1aufweist, wobei die Verjüngungen dieser Targets gegenläufig angeordnet sind. Im Wesentlichen geht es darum, dass mehrere Targets vorliegen, die unterschiedliche Resonanzfrequenzen aufweisen. Mit anderen Worten werden die einzelnen Targets so ausgebildet, dass sie die Signatur des Vektors in der Vierquadrantendarstellung so beeinflussen, dass ihre Bewegung eindeutig auswertbar ist. Gemäß Fig. 15 werden zwei dreieckförmige Targets verwendet, wobei die Spitzen dieser Dreiecke aufeinander zu zeigen. Die Targets werden gemeinsam relativ zum Sende-/ Empfangsspulensystem 1.1 entlang der Messrichtung m-m bewegt, was zu der Signatur gemäß Figur 15a führt. Die Pfeile 15.5 entsprechen dabei einzelnen Positionen des Targets. Je länger die Pfeile, desto klarer lässt sich die Position auswerten, denn desto größer ist der Rauschabstand. Bereits dadurch wird eine klare Signatur erhalten, die eine exaktere Auswertung mit höherer Sensitivität der Sensoranordnung ermöglicht. Dabei können anstelle der Dreiecke auch rautenförmige Targets verwendet werden, wie sie in Fig. 16 Anwendung finden.

Denkbar ist auch die Verwendung eines Gitterrasters, das insofern sich nicht verjüngt, wobei die Raster des sprossenleiterartigen Gitters in den Kurzschlusskreisen verschiedene Kapazitäten aufweisen, die entsprechend bei Bewegung des Targets auswertbar sind.

Bei den Ausführungsbeispielen der Figuren 15 und 16 befinden sich die Targets 15.2, 16.1 auf einer Leiterplatte 15.1 und sind als gedruckte Leiterbahnen ausgebildet, die gemeinsam mit der Leiterplatte in Messrichtung m bewegt werden. Mit anderen Worten muss also nicht ein vollflächiges Target verwendet werden, sondern es genügt die Verwendung lediglich einer oder auch mehrerer paralleler Leiterbahnen.

In Fig. 15 sind auf der Leiterplatte 15.1 zwei Targets 15.2 als Leiterbahn ausgebildet. Den Leiterbahnen zugeordnet ist jeweils ein Kondensator 15.3, 15.4. Damit bilden die Leiterbahnen mit dem Kondensator 15.3, 15.4 jeweils Schwingkreise S1, S2, was ebenfalls gerade in Verbindung mit dem getakteten Sendesignal 17.1 zu einer entsprechenden Signatur gemäß Fig. 15a führt. Vorzugsweise sind die Kondensatoren 15.3, 15.4 ungleich, so dass sich verschiedene Resonanzen der Targets einstellen.

Grundsätzlich können wie in Fig. 16 durch das gestrichelte Target 16.1 dargestellt, die Targets auf gegenüberliegenden Seiten der Leiterplatte 15.1 angeordnet werden. Das Target 16.1 ist dabei rautenförmig ausgebildet und bildet zusammen mit einem Kondensator 16.2 ebenfalls einen Schwingkreis S5. Die Targets 15.2, 16.1 sind mit ihren Spitzen teilweise übereinander liegend gegenläufig angeordnet und bilden mehrere Schwingkreise S3, S4, S5. Gemäß Fig. 16a ergibt sich eine eindeutige Signatur, die deutlich den Unterschied zu den vorbekannten Signaturen zeigt. Mit dieser klaren Signatur lässt sich eine deutlich höhere Sensitivität und damit bessere Auswertung der detektierten Signale erreichen.

Verfahrensgemäß erfolgt die Detektion der Position eines Targets unter Verwendung der induktiven Sensoranordnung. Das Sende-/ Empfangsspulensystem 1.1 ist so gestaltet oder auch geometrisch so geformt und/oder kalibriert, dass am Ausgang des Sende-/ Empfangsspulensystems ohne Metalleinfluss im Detektionsbereich 10 das Ausgangssignal ein Nullsignal ist. Ist das Ausgangssignal ein Signal ungleich Null, weist es eine bestimmte Amplitude und Phase auf. Über den Regelungstreiber wird dieses Signal über einen geschlossenen Regelkreis mit einem auf den Empfangspfad einwirkenden Regelsignal auch bei Vorhandensein eines Targets im Detektionsbereich auf den ausgeregelten Zustand geregelt. Dem Regelsignal ist die Abweichung $\Delta x$, $\Delta y$ vom ausgeregelten bzw. kalibrierten Zustand als Position oder, wenn benötigt, als Abstandsinformation zur Detektion der Position des Targets immanent.

Die Bestimmung des Regelsignals erfolgt dadurch, dass in einer digitalen Auswertung die bei 0° und 180° bestimmte Amplitude und Phase der den beiden Taktphasen zugeordneten Empfangssignale 17.3, 17.4 in einer ersten Korrektur mit einem Korrektursignal 17.5 dadurch im Empfangspfad zu Null geregelt wird, dass die Phasen der den Taktphasen zugeordneten Empfangssignale gegenläufig zueinander verschoben werden, was der Pfeil 17.9 deutlich macht. In einer zweiten Korrektur werden Amplitude und Phase bei 90° und 270° bestimmt, was die Signale 17.6 und 17.7 zeigen. Dies führt zu dem Korrektursignal 17.8. Falls erforderlich könnten auch die Signale 17.6 und 17.7 gegenläufig verschoben werden, um ein Korrektursignal 17.8 zu bewirken. Das Verschieben der Phasen der den Taktphasen zugeordneten Empfangssignale kann auch durch Pulsweitenmodulation erfolgen.

Gemäß Fig. 18 werden die Signale in einem Mikroprozessor 18 so verarbeitet, dass an den Ausgängen des Mikroprozessors die Signale 17.3 und 17.4 anstehen, die zum ersten Korrektursignal 17.5 summiert werden, sowie die Signale 17.6 und 17.7, die zum Korrektursignal 17.8 summiert werden. Beide Korrektursignale führen dann zur endgültigen Korrektur C.

Die verfahrensgemäße Vorgehensweise der Verschiebung der Phasen der Takte zueinander als auch die Anordnung und Ausgestaltung der Targets 15.2, 16.1 tragen für sich und in Kombination miteinander dazu bei, dass die Sensitivität der Sensoranordnung nochmals deutlich erhöht wird. In der Praxis hat sich ein Faktor 20 herausgestellt. Dabei ist anstelle der vorbekannten analogen Auswertung eine komplett digitale Auswertung möglich. Statt die Amplitude zu regeln, wird die Amplitude festgehalten und stattdessen der Zeitabschnitt variiert, um zum Regelergebnis zu gelangen.

Angewandt wird verfahrensgemäß ein Ermitteln des Verlaufs der Abweichungen $\Delta x$, $\Delta y$ des Stell- oder Regelsignals in Form einer Vektoranalyse in einem Phasenraum des Stellsignals. In dem Phasenraum wird auf bekannte Art und Weise ein nicht zeitabhängiger Zustand des Stellsignals dargestellt. Dies kann insbesondere in einer Vierquadrantendarstellung eines xy-Achsenkreuzes erfolgen, wobei ein Punkt in dem Phasenraum jeweils einem nicht zeitabhängigen möglichen Zustand des Stellsignals entspricht. Vorteilhaft können zum Ermitteln des Verlaufes eine Vielzahl solcher Punkte ermittelt werden, die dann vorteilhaft grafisch in dem Phasenraum darstellbar sind. Die Vielzahl der Punkte kann für einen bestimmten Gegenstand eine Funktion des Stellsignales abhängig von der Entfernung darstellen. Damit kann z.B. zu einem beliebigen Zeitpunkt eine Momentaufnahme des Stellsignals mit dem ermittelten Verlauf verglichen werden. Dies erfolgt vorzugsweise in einem eingeschwungenen Zustand des Regelkreises beziehungsweise des Reglers. Es erfolgt also vorzugsweise zunächst ein Einschwingen des Regelkreises und/oder Reglers beziehungsweise ein Einstellen des Sollwerts. Sofern sich dabei eine Übereinstimmung und/oder eine ungefähre Übereinstimmung ergibt, kann unter der Voraussetzung, dass sich nur der Gegenstand im Detektionsbereich der Sensoreinheit befindet, zumindest qualitativ auf die Entfernung geschlossen werden.

Ein Ermitteln eines derartigen Verlaufs kann auch während eines Annäherns der Sensoreinheit an den Gegenstand vor einer Detektion des Objekts erfolgen. Unter Ermitteln kann verstanden werden, dass die Punkte des Stellsignals in dem Phasenraum während des Annäherns ermittelt und gespeichert werden. Dies kann erfolgen, sobald der Gegenstand detektiert wird, also ein von einem unbelasteten Zustand abweichender Punkt in dem Phasenraum auftritt. Dies kann mehrfach erfolgen, sodass eine Punkteschar, die den Verlauf bildet, ermittelbar ist. So kann der Verlauf unmittelbar vor einer eigentlichen Messung, also dem Detektieren ermittelt werden. Alternativ ist es denkbar, den Verlauf nicht unmittelbar vor dem Detektieren des Objekts zu ermitteln, sondern in vorgelagerten Versuchen mit einer Vielzahl von Gegenständen, wobei für jeden einzelnen der Gegenstände ein entsprechender Verlauf in einer entsprechenden Tabelle abspeicherbar ist. Während der eigentlichen Messung kann dann zum Ermitteln des Verlaufs nicht eine Messung desselben, sondern lediglich eine Auswahl aus der vorab gespeicherten Tabelle erfolgen. Auf diese Art und Weise kann ebenfalls für den aktuell vorliegenden Gegenstand der passende Verlauf des Stellsignals in dem Phasenraum ermittelt werden.

Eine weitere Ausführungsform des Verfahrens erfolgt durch Vorgeben eines Schwellwerts für den Verlauf, Vergleichen des Stellsignals mit dem Schwellwert und Detektieren des Objekts, sobald das Stellsignal so weit von dem Verlauf abweicht, dass der Schwellwert überschritten ist. Unter einem Schwellwert wird eine Entfernung von einem einzelnen Punkt und/oder von dem Verlauf verstanden. Insbesondere kann es sich dabei um eine Umgebung um den Verlauf handeln, wobei die Umgebung in dem Phasenraum darstellbar ist. Unter einem Überschreiten des Schwellwerts ist ein Verlassen der Umgebung zu verstehen.

Abstrahiert auf eine beliebige Sensoreinheit wird also wenigstens ein physikalischer Parameter mittels einer Sensoreinheit ermittelt, die durch mindestens eine periodische Anregung 1.4 erregt wird. Die Sensoreinheit weist wenigstens einen Detektionsbereich 10 auf, in dem Änderungen des Parameters im Umfeld der Sensoreinheit zu einem Ausgangssignal 1.7 der Sensoreinheit führen. Die Sensoreinheit ist so beschaltet, dass am Ausgang der Sensoreinheit ohne Änderungen des Parameters im Detektionsbereich 10 das Ausgangssignal 1.7 ein Nullsignal oder ein nahezu Nullsignal ist, während bei Änderungen des Parameters im Detektionsbereich 10 das Ausgangssignal 1.7 ein Signal ungleich Null ist, das eine bestimmte Amplitude und Phase aufweist. In einem geschlossenen Regelkreis wird mit einem Regelsignal 1.6 das Signal ungleich Null im Empfangspfad auch bei Vorhandensein von Änderungen des Parameters im Detektionsbereich 10 zur Erzielung eines ausgeregelten Zustands zu Null ausgeregelt.

Bei Verwendung eines homogenen Targets, dessen Zusammensetzung oder Form sich nicht entlang der Messrichtung m ändert, lässt sich aus der in der Regelabweichung enthaltenen Information anspruchsgemäß der Abstand des Targets von der Sensoranordnung also normal zur Messrichtung m bestimmen, ohne dass eine Messung entlang der Messrichtung m erfolgt oder erfolgen muss. Daraus ergibt sich die Funktion eines Abstands- oder Proximity-Sensors. Die Werte in oder normal zur Messrichtung können also unabhängig voneinander ermittelt werden.

**Bezugszeichenliste**

| | | | | |
|---|---|---|---|---|
| 1.1 | Spulensystem | | 10 | Detektionsbereich |
| 1.2 | Target | | 13.1 | Sendespule |
| 1.3 | Sendetreiber | | 13.2 | Empfangsspule |
| 1.4 | Sendesignal | | 13.3 | Sendesignal |
| 1.5 | Regelungstreiber | | 13.4 | Verstärker |
| 1.6 | Regelsignal | | 14.1 | Sende-/Empfangsspule |
| 1.7 | Empfangspfad | | 14.2 | Referenzspule |
| 1.8 | Demodulation | | 15.1 | Leiterplatte |
| 1.9 | Analog-Digitalwandler | | 15.2 | Target als Leiterbahn |
| 1.10 | Microcontroller | | 15.3, 15.4 | Kondensator |
| 2.1 | Signalkurve | | 16.1 | rautenförmiges Target |
| 2.2 | Signalkurve | | 16.2 | Kondensator |
| 2.3 | Signalkurve | | S1 ... S5 | Schwingkreis |
| 2.4 | Signalkurve | | 17.1 | Sendesignal |
| 2.5 | Messpunkt | | 17.2 | Empfangssignal |
| 2.6 | Vektor | | 17.3, 17.4 | Signalverläufe |
| 2.7 | Ursprung des Koordinatensystems | | 17.5, 17.8 | Korrektursignal |
| | | | 17.6, 17,7 | Signalverlauf |
| 3.3, a-a | Rotationsachse | | 17.9 | Pfeil |
| 4.1 | Rotationskörper (Welle) | | 18 | Mikroprozessor |
| 5.1 | Signalverlauf eines ersten Spulensystems | | m | Messrichtung |
| 5.2 | Signalverlauf eines zweiten Spulensystems | | n | Richtung normal zur Messrichtung |
| 5.3 | Umschaltpunkt | | $\Delta x$, $\Delta y$ | Abweichung des Regelsignals |
| 5.4 | Sprungstelle des Signalverlaufs | | C | Korrektur |

**Patentansprüche**

**1.** Sensoranordnung

    - mit einer Sensoreinheit,
    - mit wenigstens einem mit der Sensoreinheit zusammenwirkenden Target (1.2),
    - mit Mitteln (1.10) zur Signalaufbereitung,

- wobei die Sensoranordnung zur induktiven oder kapazitiven Detektion des wenigstens einen Targets durch Ermittlung wenigstens eines physikalischen Parameters mittels der Sensoreinheit bestimmt und geeignet ist, die durch mindestens eine periodische Anregung (1.4) erregt wird,
- wobei die Sensoreinheit wenigstens einen Detektionsbereich (10) aufweist, in dem das wenigstens eine Target (1.2) zu Änderungen des Parameters im Umfeld der Sensoreinheit und damit zu einem Ausgangssignal (1.7) der Sensoreinheit führt,
- wobei die Sensoreinheit so beschaltet ist, dass

  - am Ausgang der Sensoreinheit ohne Änderungen des Parameters im Detektionsbereich (10) das Ausgangssignal (1.7) ein Nullsignal ist,
  - während bei Änderungen des Parameters im Detektionsbereich (10) das Ausgangssignal (1.7) ein Signal ungleich Null ist, das eine bestimmte Amplitude und Phase aufweist,

- wobei die Mittel (1.10) zur Signalaufbereitung dazu eingerichtet sind, in einem geschlossenen Regelkreis mit einem Regelsignal (1.6) das Signal ungleich Null im Empfangspfad auch bei Vorhandensein von Änderungen des Parameters im Detektionsbereich (10) zur Erzielung eines ausgeregelten Zustands zu Null auszuregeln,
- wobei dem zur Erzielung des ausgeregelten Zustands erforderlichen Regelsignal (1.6) eine Abweichung ($\Delta x$, $\Delta y$) des Regelsignals von einem ausgeregelten Ausgangszustand als Information über den Parameter immanent ist,
**dadurch gekennzeichnet, dass** das Target (1.2) eine Form oder Zusammensetzung aufweist, die sich entlang einer Messrichtung (m) ändert, und dass mittels den Mitteln (1.10) zur Signalaufbereitung bei einer Vierquadrantendarstellung der Abweichung ($\Delta x$, $\Delta y$) des Regelsignals in Form einer Vektoranalyse in einem Phasenraum
- der Abstand des Targets (1.2) von der Sensoreinheit in Richtung des Abstands aufgrund eines Betrags eines gedachten Vektors (2.6), der vom Ursprung (2.7) eines x-, y-Koordinatensystems zu einem Messpunkt (2.5) führt, welcher Ursprung (2.7) dem ausgeregelten Ausgangszustand entspricht, ermittelt wird ist und/oder
- wenigstens eine der Größen umfassend eine Position des Targets, eine quer zur Richtung des Abstands erfolgende Bewegung des Targets, eine Materialeigenschaft des Targets, eine Form des Targets, eine Größe der Fläche des Targets aufgrund eines Winkels des gedachten Vektors (2.6) zur x-Achse des x-, y-Koordinatensystems ermittelt wird.

2. Sensoranordnung nach Anspruch 1, **dadurch gekennzeichnet, dass** der physikalische Parameter zur induktiven Detektion der Position oder Bewegung des wenigstens einen Targets (1.2) bestimmbar ist und dass die Sensoreinheit wenigstens ein Sende-/ Empfangsspulensystem (1.1) ist, das aus wenigstens zwei Spulen aufgebaut ist und den Detektionsbereich (10) aufweist,
wobei dem Regelsignal (1.6) die Abweichung des Regelsignals vom ausgeregelten Zustand als Abstandsinformation zur Detektion der Position des wenigstens einen Targets (1.2) immanent ist,
wobei die Bewegung des wenigstens einen Targets (1.2) in Messrichtung (m) aufgrund des Winkels des gedachten Vektors (2.6) ermittelt wird und/oder der Abstand des wenigstens einen Targets (1.2) vom Sende-/Empfangsspulensystems (1.1) normal zur Messrichtung (m) aufgrund des Betrags des gedachten Vektors (2.6) ermittelt wird.

3. Sensoranordnung nach Anspruch 1 oder 2, **dadurch gekennzeichnet, dass** die Regelung (1.5) eine kontinuierliche Regelung ist.

4. Sensoranordnung nach einem der vorhergehenden Ansprüche, **dadurch gekennzeichnet, dass** das wenigstens eine Target (1.2) ein kreisbogenförmiges, sich verjüngendes Target ist oder ein rotationssymmetrisches, kegelförmiges Target ist.

5. Sensoranordnung nach einem der vorhergehenden Ansprüche, **dadurch gekennzeichnet, dass** mehrere Targets (15.2, 16.1) vorgesehen sind, die unterschiedliche Resonanzfrequenzen aufweisen, oder dass ein Target mehrere sich entlang der Messrichtung (m) verjüngende Targets (15.2, 16.1) aufweist, deren Verjüngungen gegenläufig angeordnet sind.

6. Sensoranordnung nach Anspruch 5, **dadurch gekennzeichnet, dass** die mehreren Targets (15.2, 16.1) dreieckförmig oder rautenförmig sind, wobei die Spitzen der Dreiecke oder Rauten aufeinander zu zeigen.

7. Sensoranordnung nach einem der Ansprüche 2 bis 6, **dadurch gekennzeichnet, dass** das Sende/Empfangsspulensystem (1.1) wenigstens zwei an unterschiedlichen Rotationswinkelpositionen des Targets (1.2) angeordnete Sende/Empfangsspulensysteme umfasst, wobei vorzugsweise sich zwei Sende/Empfangsspulensysteme (1.1) hinsichtlich der Rotationsachse (a-a) des Targets (1.2) diametral gegenüberliegen.

8. Sensoranordnung nach einem der vorhergehenden Ansprüche, **dadurch gekennzeichnet, dass** das wenigstens eine Target (1.2) am Umfang eines Rotationskörpers (4.1) aufgebracht ist, wobei vorzugsweise mehrere Targets (1.2) räumlich und hinsichtlich ihrer Winkellage am Rotationskörper (4.1) versetzt aufgebracht sind.

9. Verfahren zur induktiven oder kapazitiven Ermittlung wenigstens eines physikalischen Parameters mittels einer Sensoreinheit und wenigstens einem damit zusammenwirkenden Target (1.2), wobei die Sensoreinheit durch mindestens eine periodische Anregung (1.4) erregt wird und wenigstens einen Detektionsbereich (10) aufweist, in dem das wenigstens eine Target (1.2) zu Änderungen des Parameters im Umfeld der Sensoreinheit und damit zu einem Ausgangssignal (1.7) der Sensoreinheit führt, das mit Mitteln (1.10) zur Signalaufbereitung aufbereitet wird,

- wobei die Sensoreinheit so beschaltet ist, dass

- am Ausgang der Sensoreinheit ohne Änderungen des Parameters im Detektionsbereich (10) das Ausgangssignal (1.7) ein Nullsignal ist,
- während bei Änderungen des Parameters im Detektionsbereich (10) das Ausgangssignal (1.7) ein Signal ungleich Null ist, das eine bestimmte Amplitude und Phase aufweist,

- wobei die Mittel (1.10) zur Signalaufbereitung in einem geschlossenen Regelkreis mit einem Regelsignal (1.6) das Signal ungleich Null im Empfangspfad auch bei Vorhandensein von Änderungen des Parameters im Detektionsbereich (10) zur Erzielung eines ausgeregelten Zustands zu Null ausregeln,
- wobei dem zur Erzielung des ausgeregelten Zustands erforderlichen Regelsignal (1.6) eine Abweichung des Regelsignals von einem ausgeregelten Ausgangszustand immanent ist,
**dadurch gekennzeichnet, dass** als das wenigstens eine Target (1.2) ein Target verwendet wird, das eine Form oder Zusammensetzung aufweist, die sich entlang einer Messrichtung (m) ändert, und dass bei einer Vierquadrantendarstellung der Abweichung ($\Delta$x, $\Delta$y) des Regelsignals in Form einer Vektoranalyse in einem Phasenraum

- der Abstand des Targets von der Sensoreinheit in Richtung des Abstands aufgrund eines Betrags eines gedachten Vektors (2.6), der vom Ursprung (2.7) eines x-, y-Koordinatensystems zu einem Messpunkt (2.5) führt, welcher Ursprung (2.7) dem ausgeregelten Ausgangszustand entspricht, ermittelt wird und/oder
- wenigstens eine der Größen umfassend eine Position des Targets, eine quer zur Richtung des Abstands erfolgende Bewegung des Targets, eine Materialeigenschaft des Targets, eine Form des Targets, eine Größe der Fläche des Targets aufgrund eines Winkels des gedachten Vektors (2.6) zur x-Achse des x-, y-Koordinatensystems ermittelt wird.

10. Verfahren nach Anspruch 9, **dadurch gekennzeichnet, dass** zur induktiven Detektion der Position oder Bewegung des wenigstens einen Targets (1.2) eine Sensoreinheit mit wenigstens einem Sende/Empfangsspulensystem (1.1) verwendet wird, das aus wenigstens zwei Spulen aufgebaut ist und den Detektionsbereich (10) aufweist, wobei dem Regelsignal (1.6) die Abweichung des Regelsignals vom ausgeregelten Zustand als Abstandsinformation zur Detektion der Position des wenigstens einen Targets (1.2) immanent ist, wobei die Bewegung des wenigstens einen Targets (1.2) in Messrichtung (m) aufgrund des Winkels des gedachten Vektors (2.6) und/oder der Abstand des wenigstens einen Targets (1.2) vom Sende-/Empfangsspulensystems (1.1) normal zur Messrichtung (m) aufgrund des Betrags des gedachten Vektors (2.6) ermittelt wird.

11. Verfahren nach Anspruch 9 oder 10, **dadurch gekennzeichnet, dass** das Signal ungleich Null zur Erzielung eines ausgeregelten Zustands zu Null kontinuierlich ausgeregelt wird,

**Claims**

1. A sensor arrangement comprising

- a sensor unit,
- at least one target (1.2) cooperating with the sensor unit,
- means (1.10) for signal processing,
- wherein the sensor arrangement is intended and suitable for inductive or capacitive detection of the at least one target by determining at least one physical parameter by means of the sensor unit, which is excited by at least one periodic excitation (1.4)
- wherein the sensor unit comprises at least one detection area (10) in which the at least one target (1.2) leads to changes in the parameter in the environment of the sensor unit and thus results in an output signal (1.7) of the sensor unit,
- wherein the sensor unit is connected such that,

- if there are no changes in the parameter in the detection region (10), the output signal (1.7) at the output of the sensor unit is a zero signal,
- whereas in the event of changes in the parameter in the detection region (10) the output signal (1.7) is a signal not equal to zero and having a particular amplitude and phase,

- wherein the means (1.10) for signal processing are configured to adjust the signal not equal to zero in the receiving path to zero in a closed control loop with a control signal (1.6) even in the presence of changes in the parameter in the detection region (10) to achieve a compensated condition,
- wherein a deviation ($\Delta$x, $\Delta$y) in the control signal, required for the purpose of achieving the compensated condition, from a compensated initial condition, as information on the parameter, is inherent in the control signal (1.6),
**characterised in that** the target (1.2) comprises a shape or composition which changes along a measuring direction (m), and **in that**, by means of the means (1.10) for signal processing, in a four-quadrant representation of the deviation ($\Delta$x, $\Delta$y) of the control signal in the form of a vector analysis in a phase space
- the distance of the target (1.2) from the sensor unit in the direction of the distance is determined on the basis of a magnitude of an imaginary vector (2.6) which leads from the origin (2.7) of an x, y coordinate system to a measuring point (2.5), which origin (2.7) corresponds to the compensated initial condition, and/or
- at least one of the variables comprising a position of the target, a movement of the target transverse to the direction of the distance, a material property of the target, a shape of the target, a size of the surface of the target is determined on the basis of an angle of the imaginary vector (2.6) to the x-axis of the x, y-coordinate system.

2. A sensor arrangement according to Claim 1, **characterized in that** the physical parameter is determinable for inductive detection of the position or movement of the at least one target (1.2), and **in that** the sensor unit is at least one transmitting/receiving coil system (1.1), which is formed by at least two coils and comprises the detection region (10),
wherein the deviation of the control signal from the compensated condition is inherent in the control signal (1.6) as distance information for detection of the position of the at least one target (1.2),
wherein the movement of the at least one target (1.2) in the measuring direction (m) is determined on the basis of the angle of the imaginary vector (2.6) and/or the distance of the at least one target (1.2) from the transmitting/receiving coil system (1.1) normal to the measuring direction (m) is determined on the basis of the magnitude of the imaginary vector (2.6).

3. A sensor arrangement according to Claim 1 or 2, **characterized in that** the control (1.5) is a continuous control.

4. A sensor arrangement according to one of the preceding claims, **characterized in that** the at least one target (1.2) is an arcuate, tapering target or is a rotationally symmetrical, conical target.

5. A sensor arrangement according to one of the preceding claims, **characterized in that** a plurality of targets (15.2, 16.1) are provided that have different resonant frequencies, or **in that** one target comprises a plurality of targets (15.2, 16.1) that taper in the measuring direction (m) and taper in opposed directions.

6. A sensor arrangement according to Claim 5, **characterized in that** the plurality of targets (15.2, 16.1) are triangular or rhomboid, wherein the apices of the triangles or the points of the lozenges point towards one another.

7. A sensor arrangement according to one of Claims 2 to 6, **characterized in that** the transmitting/receiving coil system (1.1) includes at least two transmitting/receiving coil systems that are arranged at different rotational angle positions of the target (1.2), wherein preferably two transmitting/receiving coil systems (1.1) are diametrically opposed with respect to the rotational axis (a-a) of the target (1.2).

8. A sensor arrangement according to one of the preceding claims, **characterized in that** the at least one target (1.2) is mounted on the periphery of a rotational body (4.1), wherein preferably several targets (1.2) are mounted spatially and offset with respect to their angular position on the rotational body (4.1).

9. A method for inductive or capacitive determination of at least one physical parameter by means of a sensor unit and at least one target (1.2) cooperating therewith, the sensor unit being excited by at least one periodic excitation (1.4) and comprising at least one detection region (10) in which the at least one target (1.2) leads to changes in the parameter in the environment of the sensor unit and thus results in an output signal (1.7) of the sensor unit, , which is processed by means (1.10) for signal processing,

- wherein the sensor unit is connected such that,

- if there are no changes in the parameter in the detection region (10), the output signal (1.7) at the output of the sensor unit is a zero signal,
- whereas in the event of changes in the parameter in the detection region (10) the output signal (1.7) is a signal not equal to zero and having a particular amplitude and phase,

- wherein the means (1.10) for signal processing in a closed control loop with a control signal (1.6) adjust the signal not equal to zero in the receiving path to zero even in the presence of changes in the parameter in the detection area (10) to achieve a compensated condition,
- wherein the control signal (1.6) required to achieve the compensated condition is inherent to a deviation of the control signal from a compensated initial condition,
- wherein a deviation in the control signal, required for the purpose of achieving the compensated condition, from a compensated initial condition is inherent in the control signal (1.6),
**characterised in that** a target is used as the at least one target (1.2) which has a shape or composition which changes along a measuring direction (m), and **in that** in a four-quadrant representation of the deviation ($\Delta x$, $\Delta y$) of the control signal in the form of a vector analysis in a phase space
- the distance of the target from the sensor unit in the direction of the distance is determined on the basis of a magnitude of an imaginary vector (2.6) leading from the origin (2.7) of an x, y coordinate system to a measuring point (2.5), which origin (2.7) corresponds to the compensated initial state, and/or
- at least one of the variables comprising a position of the target, a movement of the target transverse to the direction of the distance, a material property of the target, a shape of the target, a size of the surface of the target is determined on the basis of an angle of the imaginary vector (2.6) to the x-axis of the x, y-coordinate system.

10. Method according to claim 9, **characterised in that** for the inductive detection of the position or movement of the at least one target (1.2) a sensor unit with at least one transmitting/receiving coil system (1.1) is used, which is constructed from at least two coils and comprises the detection area (10),
wherein the deviation of the control signal from the compensated condition is immanent to the control signal (1.6) as distance information for detecting the position of the at least one target (1.2),
wherein the movement of the at least one target (1.2) in the measuring direction (m) is determined on the basis of the angle of the imaginary vector (2.6) and/or the distance of the at least one target (1.2) from the transmitting/receiving coil system (1.1) normal to the measuring direction (m) is determined on the basis of the magnitude of the imaginary vector (2.6).

11. Method according to claim 9 or 10, **characterised in that** the signal not equal to zero is continuously adjusted to zero to achieve a compensated condition.

**Revendications**

1. Dispositif de détection comportant

- une unité de détection,
- au moins une cible (1.2) coopérant avec l'unité de détection,
- des moyens (1.10) pour le traitement d'un signal,
- dans lequel le dispositif de détection est conçu et approprié pour une détection inductive ou capacitive de la ou des cible(s) par la détermination d'au moins un paramètre physique au moyen de l'unité de détection qui est excitée par au moins une excitation périodique (1.4),

- dans lequel l'unité de détection comprenant au moins une zone de détection (10), dans laquelle la ou les cible(s) (1.2) condui(sen)t à des variations du paramètre dans l'environnement de l'unité de détection et ainsi à un signal de sortie (1.7),
- dans lequel l'unité de détection est connectée de telle sorte que

- à la sortie de l'unité de détection, le signal de sortie (1.7) est un signal nul en l'absence de variations du paramètre dans la zone de détection (10),
- tandis qu'en cas de variations du paramètre dans la zone de détection (10), le signal de sortie (1.7) est un signal différent de zéro qui présente une amplitude et une phase déterminées,

- dans lequel les moyens (1.10) pour le traitement du signal sont configurés pour mettre à zéro, dans un circuit de réglage fermé, avec un signal de réglage (1,6), le signal différent de zéro dans le chemin de réception également en présence de variations du paramètre dans la zone de détection (10), pour l'obtention d'un état réglé,
- dans lequel une déviation ($\Delta$x, $\Delta$y) du signal de réglage par rapport à un état initial réglé est immanente au signal de réglage nécessaire pour l'obtention de l'état réglé (1.6) en tant qu'information sur le paramètre, **caractérisé en ce que** la cible (1.2) présente une forme ou composition, qui varie le long d'une direction de mesure (m), et **en ce qu'**au moyen des moyens (1.10) pour le traitement du signal lors d'une représentation à quatre cadrans de la déviation ($\Delta$x, $\Delta$y) du signal de réglage sous la forme d'une analyse vectorielle dans un espace des phases,

- la distance de la cible (1.2) par rapport à l'unité de détection dans la direction de la distance est déterminée sur la base d'une valeur d'un facteur imaginaire (2.6), qui conduit de l'origine (2.7) d'un système de coordonnées x,y à un point de mesure (2.5), dont l'origine (2.7) correspond à l'état initial réglé et/ou
- au moins une des grandeurs parmi une position de la cible, un déplacement de la cible se produisant perpendiculairement à la direction de la distance, une propriété du matériau de la cible, une forme de la cible, une dimension de la surface de la cible, est déterminée sur la base d'un angle du vecteur imaginaire (2.6) par rapport à l'axe des x du système de coordonnées x,y.

2. Dispositif de détection selon la revendication 1, **caractérisé en ce que** le paramètre physique pour la détection inductive de la position ou du déplacement de la ou des cible(s) (1.2) est déterminable et **en ce que** l'unité de détection est au moins un système à bobine d'émission/réception (1.1), lequel est constitué d'au moins deux bobines et comporte la zone de détection (10),
dans lequel la déviation du signal de réglage (1.6) par rapport à l'état réglé est immanente au signal de réglage (1.6) en tant qu'information de distance pour la détection de la position de la ou des cible(s) (1.2),
dans lequel le déplacement de la ou des cible(s) (1.2) dans la direction de mesure (m) est déterminé sur la base de l'angle du vecteur imaginaire (2.6) et/ou la distance de la ou des cible(s) (1.2) par rapport au système à bobine d'émission/réception (1.1) est déterminée perpendiculairement à la direction de mesure (m) sur la base de la valeur du vecteur imaginaire (2.6).

3. Dispositif de détection selon la revendication 1 ou 2, **caractérisé en ce que** le réglage (1.5) est un réglage continu.

4. Dispositif de détection selon l'une des revendications précédentes, **caractérisé en ce que** la ou les cible(s) (1.2) est/sont une cible en forme d'arc de cercle s'amincissant ou une cible à symétrie de rotation, tronconique.

5. Dispositif de détection selon l'une des revendications précédentes, **caractérisé en ce que** plusieurs cibles (15.2, 16.2) sont prévues, qui présentent des fréquences de résonance différentes, ou **en ce qu'**une cible comporte plusieurs cibles (15.2, 16.1) s'amincissant le long de la direction de mesure (m) et dont les amincissements sont disposés de manière opposée.

6. Dispositif de détection selon la revendication 5, **caractérisé en ce que** les différentes cibles (15.2, 16.1) sont triangulaires ou en forme de losange, les sommets des triangles ou losanges pointant les uns vers les autres.

7. Dispositif de détection selon l'une des revendications 2 à 6, **caractérisé en ce que** le système à bobine d'émission/réception (1.1) comprend au moins deux systèmes à bobine d'émission/réception disposés à des positions angulaires de rotation de la cible (1.2) différentes, de préférence deux systèmes à bobine d'émission/réception se recouvrant diamétralement par rapport à l'axe de rotation (a-a) de la cible (1.2).

**8.** Dispositif de détection selon l'une des revendications précédentes, **caractérisé en ce que** la ou les cible(s) (1.2) est/sont appliquée(s) dans l'environnement d'un corps de rotation (4.1), de préférence plusieurs cibles (1.2) étant appliquées sur le corps rotatif (4.1) de manière décalée dans l'espace et par rapport à leur position angulaire.

**9.** Procédé de détermination inductive ou capacitive d'au moins un paramètre physique au moyen d'une unité de détection et d'au moins une cible (1.2) coopérant avec elle, dans lequel l'unité de détection est excitée à l'aide d'au moins une excitation périodique (1.4), et comprend au moins une zone de détection (10), dans laquelle la ou les cible(s) (1.2) condui(sen)t à des variations du paramètres dans l'environnement de l'unité de détection et ainsi à un signal de sortie (1.7) de l'unité de détection qui est traité avec des moyens (1.10) de traitement de signal,

- dans lequel l'unité de détection est connectée de telle sorte que

- à la sortie de l'unité de détection, le signal de sortie (1.7), en l'absence de variations du paramètre dans la zone de détection (10) est un signal nul,
- tandis qu'en cas de variations du paramètre dans la zone de détection (10), le signal de sortie (1.7) est un signal différent de zéro qui a une amplitude et une phase déterminées,

- dans lequel les moyens (1.10) de traitement de signal mettent à zéro, dans un circuit de réglage fermé, avec le signal de réglage (1.6), le signal différent de zéro dans le chemin de réception également en présence de variations du paramètre dans la zone de détection (10) pour l'obtention d'un état réglé,
- dans lequel une déviation du signal de réglage par rapport à un état initial réglé est immanente au signal de réglage nécessaire pour l'obtention de l'état réglé,
**caractérisé en ce qu'**en tant que cible(s) (1.2) est utilisée une cible qui présente une forme ou une composition qui varie le long d'une direction de mesure (m) et **en ce que** lors d'une représentation à quatre quadrants de la déviation ($\Delta$x, $\Delta$y) du signal de réglage sous la forme d'une analyse vectorielle dans un espace des phases

- la distance de la cible par rapport à l'unité de détection dans la direction de la distance est déterminée sur la base d'une valeur d'un vecteur imaginaire (2.6), qui conduit de l'origine (2.7) d'un système de coordonnées x,y à un point de mesure (2.5) dont l'origine (2.7) correspond à l'état initial réglé et/ou
- au moins l'une des grandeurs parmi une position de la cible, un déplacement de la cible se produisant perpendiculairement à la direction de la distance, une propriété du matériau de la cible, une forme de la cible, une dimension de la surface de la cible est déterminée sur la base d'un angle du vecteur imaginaire (2.6) par rapport à l'axe des x du système de coordonnées x,y.

**10.** Procédé selon la revendication 9, **caractérisé en ce qu'**est utilisée, pour la détection inductive de la position ou du déplacement de la ou des cible(s) (1.2), une unité de détection avec au moins un système à bobine d'émission/réception (1.1), qui est constitué d'au moins deux bobines et comprend la zone de détection (10),
dans lequel la déviation du signal de réglage par rapport à l'état réglé est immanente au signal de réglage (1.6) en tant qu'information de distance pour la détection de la position de la ou des cible(s) (1.2),
dans lequel le déplacement de la ou des cible(s) (1.2) est déterminé dans la direction de mesure (m) sur la base de l'angle du vecteur imaginaire (2.6) et/ou la distance de la ou des cible(s) (1.2) par rapport au système à bobine d'émission/réception (1.1) est déterminée perpendiculairement à la direction de mesure (m) sur la base de la valeur du vecteur imaginaire (2.6).

**11.** Procédé selon la revendication 9 ou 10, **caractérisé en ce que** le signal différent de zéro est réglé continuellement à zéro pour l'obtention d'un état réglé à zéro.

Fig. 1

**Fig. 2**

n-Achse
Normalenachse

10

n-Achse
Normalenachse

1.2

m-Achse
Messachse

1.1

**Fig. 3**

n-Achse
Verschiebung

1.2

1.2

1.1

**Fig. 4a**

m-Achse
Verschiebung

1.2

1.2

1.1

**Fig. 4b**

Fig. 5

Fig. 6

Rotation

3.3

1.1

Rotation

1.2

Fig. 7

3.3

1.2

1.1

Fig. 8

Fig. 9a

Fig. 9b

Fig. 10

Fig. 11

Fig. 12

13.3

13.2

13.1

13.3

13.4

Fig. 13

14.1

13.3

14.2

13.4

Fig. 14a

13.3

14.1

13.4

14.2

13.3

Fig. 14b

15.2    15.1            1.1                 15.2

15.3                                              15.4

S1                              S2      Fig. 15

ΔY

15.5                    ΔX

Fig. 15a

15.2    15.1  S5        1.1           15.2

15.3                                              15.4

S3      16.1    16.2            S4    Fig. 16

ΔY

ΔX

Fig. 16a

EP 3 084 408 B1

17.1

17.2

17.3

17.4

17.5

17.6

17.7

17.8

0°   90°   180°   270°   0°

Fig. 17

18

17.3

17.4

17.6

17.7

17.5

17.8

C

Fig. 18

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2012104086 A1
- DE 102012001202 A1
- WO 2012104086 A
- WO A1 A

**In der Beschreibung aufgeführte Nicht-Patentliteratur**

- **RICK ZARR.** Redefining inductive sensing. *ELECTRONIC DESIGN,* 04. Marz 2015, http://www.penton.com/digitaleditions/ed/ed120513_de.pdf